# EUROPEAN PATENT APPLICATION

(11) **EP 3 316 317 A1**
(43) Date of publication of application: **02.05.2018**
(21) Application number: 16196276.6
(22) Date of filing: 28.10.2016
(51) Int. Cl.: H01L 31/048

(54) **SOLAR CELL MODULE**

(71) Applicant: Nexiot AG, 8005 Zürich (CH)
(72) Inventor: Wartmann, Christoph, 8708 Männedorf (CH); Gähler, sandro, 8050 Zurich (CH)
(74) Representative: Liebetanz, Michael

(57) **Abstract**

A solar cell module (1) has a rear housing (3) to accommodate (4) a photovoltaic cell module (5) attached to the rear housing (3) and comprising an array of photovoltaic cells (6) arranged opposite to the rear housing wall (3). The solar cell module (1) further comprises a grid (20) comprising webs (22), wherein the grid (20) is attached on the upper surface (10) of the photovoltaic cell module (5) and partly on the surrounding rear housing (3), wherein the webs (22) define window openings (30) essentially provided in front of the photovoltaic cells (6) thus that the webs (22) do not shadow the photovoltaic cells (6).

## Description

### TECHNICAL FIELD

The present invention relates to a solar cell module having a rear housing to accommodate a photovoltaic cell module attached to the rear housing, wherein the photovoltaic cell module comprises an array of photovoltaic cells arranged opposite to the rear housing wall (3), according to the features of the preamble of claim 1 as well as a method producing such a solar cell module.

### PRIOR ART

WO 2016/010881 A2 relates to a portable light having a battery, wherein in [0087] it is mentioned that such a battery can also be a solar cell, fuel cells, super capacitors, solar cells, and the like. At the same time the prior art mentions the standard IEC 60079 which are for devices that are to be used in hazardous locations and/or environments.

WO 2010/147660 A2 discloses an intrinsically safe video inspection system using a photovoltaic cell 430. The device is considered to be usable under IEC 60079 conditions.

US 2001/029976 A1 describes a photovoltaic cell, wherein, when the substrate is opaque, the upper electrode layer is located on the light incident side and is able to transmit light, that is, is a transparent electrode, wherein a transparency of 85% and a low sheet resistance value is mentioned.

### SUMMARY OF THE INVENTION

Based on the prior art as shown, it is an object of the invention to provide a solar cell module being intrinsically safe in the sense of the norm IEC 60079 or similar standards for intrinsic safety. It is a further object of the invention to provide a method of making large solar cell modules complying with regulations for intrinsic safety in explosive atmospheres.

This is achieved for a solar cell module having the features of the preamble of claim 1 with the characterizing features of that claim. A solar cell module has a rear housing to accommodate a photovoltaic cell module attached to the rear housing and comprising an array of photovoltaic cells arranged opposite to the rear housing wall. The solar cell module further comprises a grid comprising webs, wherein the grid is attached on the upper surface of the photovoltaic cell module and partly on the surrounding rear housing, wherein the webs define window openings essentially provided in front of the photovoltaic cells thus that the webs do not shadow the photovoltaic cells.

The grid of the solar cell module is electrically conductive, especially made of a punched metal sheet. The grid can be attached to the photovoltaic cell module and the rear housing with an adhesive. Such an adhesive is preferredly a non-conductive adhesive but it can also be a conductive adhesive.

The solar cell module can also have a grid being printed as a screen print on the upper surface of the photovoltaic cell module and partly on the surrounding rear housing. It is then preferred to build the solar cell module within a metallic casing contacting the screen printed grid at the surrounding rear housing building an encompassing Faraday cage.

The photovoltaic cell module can be attached in a recess of the rear housing with a volume adhesive. Then it can be achieved that the upper side of the rear housing and the upper side of the photovoltaic cell module are flush so that the grid forms - together with the rear housing - a sturdy case for the solar cell module.

A method producing a solar cell module with a grid comprises the steps of providing a rear housing, positioning a photovoltaic cell module in the rear housing, providing a conductive grid, applying an adhesive either on the back side of the conductive grid or on positions complementary to the grid on the photovoltaic cell module and on the rear housing, and attaching the grid on the photovoltaic cell module and on the rear housing.

Preferably the grid, e.g. as punched sheet, is pre-bent in the direction on the surface of the photovoltaic cell module to ensure a good contact on the photovoltaic cell module.

When the photovoltaic cell module is positioned in the rear housing, it is preferred to apply a volume adhesive in a recess in the rear housing, followed by positioning the photovoltaic cell module in this recess in a way that the upper surface of the photovoltaic cell module is flush with the upper surface of the rear housing, and hardening of the volume adhesive. Then application of the grid on this flush surface ensures a good contact of the grid over the photovoltaic cell module as well as on the surrounding housing.

In order to provide a complete Faraday cage for the solar cell module, it is possible to provide an additional housing comprising a conductive layer encompassing the rear housing as well as contacting the complete edge area of the grid. Of course, the additional housing does not need to have a conductive outer surface, it is sufficient that there is an internal conductive layer ending near the grid edges and closing the inner space in the sense of said Faraday cage.

Further embodiments of the invention are laid down in the dependent claims.

### BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,
- Fig. 1: shows a perspective view of a solar cell module according to an embodiment of the invention in a case; and
- Fig. 2: shows a schematic cross section of the solar cell module according to Fig. 1.

### DESCRIPTION OF PREFERRED EMBODIMENTS

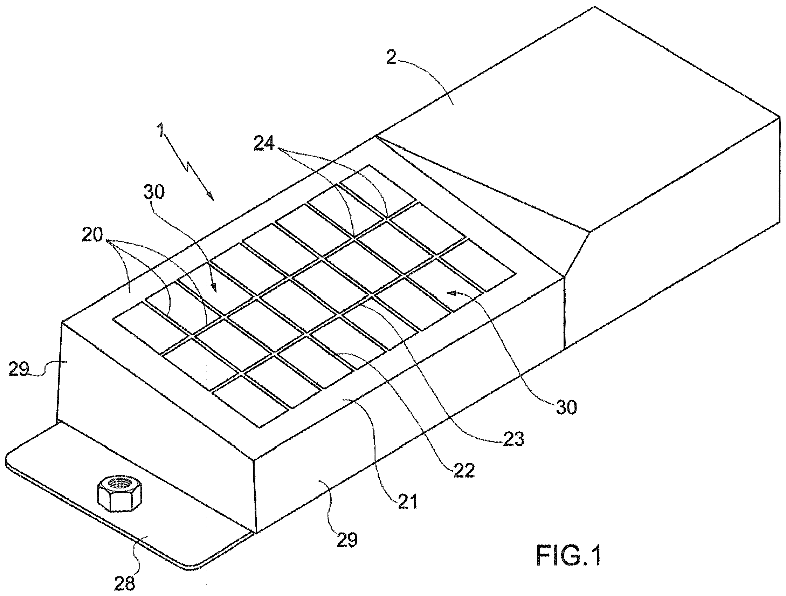

Fig. 1 shows a perspective view of a solar cell module 1 according to an embodiment of the invention in a case 2.

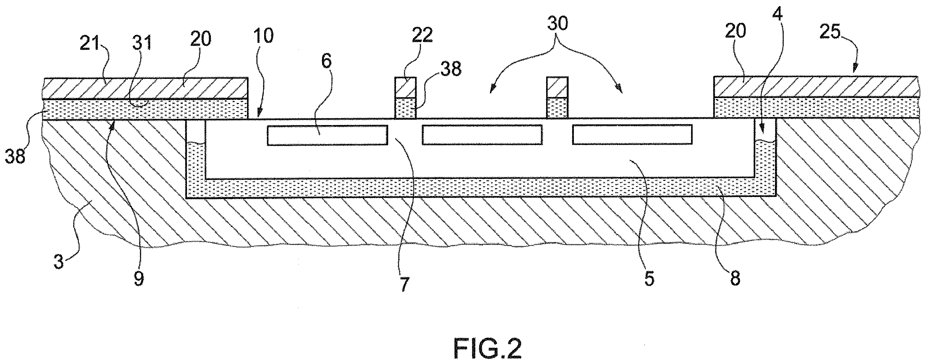

The solar cell module 1 is better shown in the schematic cross section of Fig. 2. The solar cell module 1 comprises a rear housing 3 which can be part of the case 2. The rear housing 3 comprises a recess 4, especially a rectangular recess to accommodate a photovoltaic cell module 5. A typical commercial photovoltaic cell module 5 comprises an array of single photovoltaic elements 6 embedded in a substrate 7 making up for the cuboid body of the photovoltaic cell module 5. The photovoltaic cell module 5 also comprises electrical connection lines (not shown) between the various elements in the substrate. The photovoltaic cell module 5 of the present invention does not comprise parts of control units of the photovoltaic cells 6 but it is possible to include such control units in the design. The rear housing 3 can comprise openings (not shown) for the passage of electrical connection lines of the photovoltaic cell module 5.

The photovoltaic cell module 5 is attached to the rear housing 3, preferably by an adhesive 8, which is preferredly filled into the recess 4 before accommodating the solar cell module 5. The adhesive 8 is a glue or volume adhesive to fill the space between the recess bottom and walls and the solar cell module back and side surfaces. It is possible but not necessarily preferred that the adhesive 8 does not fill the gap between the solar cell module 5 and the rear housing near the upper surface 9 of the rear housing 3. It is preferred that the upper surface 10 of the solar cell module 5 is more or less flush with the upper surface 9 of the rear housing 3.

The solar cell module 1 then further comprises a grid 20 having a circumferential side portion 21 and column webs 22 as well as crossing line webs 23. The column webs 22 and line webs 23 are connected at the crossing points 24, separating the grid surface into a plurality of windows 30. The border area 21 of the grid 20 is usually larger but is considered - according to the present invention to form part of the webs.

The grid 20 is electrically conductive. It is especially made of a metal. It is coated on the back side 31 with a further adhesive 38 used to attach said backside 31 to the upper surface 9 of the rear housing. Adhesive 38 can also be provided on the upper surface 9, but the alignment with the photovoltaic cells 6 is more complicated.

Coming back to Fig. 1, it is possible to provide a case-like grid element 20 having punched and folded side surfaces 29 and even a folded attachment flap 28, all made in one single piece. Then the Faraday cage effect is even more pronounced, since the windows 30 are the only openings to the environment, and they are sufficiently small without hindering the light to reach the active surface of the solar cell module 1.

The distances between the webs 21 and 22 of the grid 20 are chosen to be essentially in line and positioned at the portions of the photovoltaic cell module 5 which are not comprising photovoltaic cell elements 6 so that most or all of the active surfaces of the photovoltaic cell elements 6 are in front of the windows 30.

The photovoltaic cells 6 used in the embodiment shown have a size of approximately 12 x 20 millimeters which are provided in a distance of 3 millimeters one from the other in both directions (column and row). Each window has a dimension of 14 x 22 millimeters and the webs 21 and 22 have a width of 2 millimeters. Then the photovoltaic cells 6 are entirely exposed to any light falling through the windows 30.

Each window 30 has a surface of 308 mm². IEC 60079-0 (Explosive Atmospheres - Part 0: Equipment - General requirements) require a covering on a conductive material, if the surface area exceeds 500 mm². Coatings known from the prior art are not very transparent and would reduce the efficiency of the solar module 1 quite drastically. Therefore, providing a plurality of windows 30 separated with webs 21 and 22 and a border area 20, fulfils the requirements of the standard while maintaining a high efficiency of the solar module 1. Windows 30 can be up to 22 mm x 22 mm, if a square area of the photovoltaic cell 6 is available to remain below said 500 mm².

As shown in Fig. 2, the grid 20 is partly attached with its webs 21, 22 on the upper surface 10 of the photovoltaic cell module 5 and partly on the rear housing 3. This provides a solar cell module 1 comprising a rear housing 3, a photovoltaic cell module 5 with embedded solar cells 6 covered by a grid 20 dividing the upper surface 10 of the photovoltaic cell module 5 (usually far larger than 500 mm²) into an array of smaller windows 30 with the photovoltaic cells 6 behind.

In order to secure the grid 20 on the upper surface 10 and on the upper surface 9 of the photovoltaic cell module 5 and rear housing 3, respectively, the adhesive 38 is applied in advance on the back side 31 of the grid 20 and a slight preload. The preload is related to the grid 20 being bent towards the middle of the photovoltaic cell surface pushing onto it and maintaining the pressure on the adhesive.

In an embodiment not shown in the drawings the solar cell module can also have a grid 20 being printed as a screen print on the upper surface 9 of the photovoltaic cell module 5 and partly on the surrounding rear housing 3. Then the webs 22 and 23 as well as the border area 21 is directly printed on the respective areas. The screen print of electrical conductive material of e.g. 100 micrometers thickness ensures the same function as the mechanical grid 20.

### LIST OF REFERENCE SIGNS

| | | | |
|---|---|---|---|
| 1 | solar cell module | 20 | grid |
| 2 | case | 21 | border area |
| 3 | rear housing | 22 | column web |
| 4 | gap | 23 | line web |
| 5 | photovoltaic cell module | 24 | crossing point |
| 6 | photovoltaic cell | 25 | upper surface of grid |
| 7 | substrate | 28 | bottom attachment flap |
| 8 | volume adhesive | 29 | side surface |
| 9 | upper side of rear housing | 30 | window |
| 10 | upper side of photovoltaic cell module | 31 | underside of grid |
| | | 38 | adhesive |

## Claims

1. A solar cell module (1) having a rear housing (3) to accommodate (4) a photovoltaic cell module (5) attached to the rear housing (3), wherein the photovoltaic cell module (5) comprises an array of photovoltaic cells (6) arranged opposite to the rear housing wall (3), **characterized in that** the solar cell module (1) further comprises a electrically conductive grid (20) comprising webs (21, 22, 23), wherein the grid (20) is attached on the upper surface (10) of the photovoltaic cell module (5) and partly on the surrounding rear housing (3), wherein the webs (21, 22, 23) define window openings (30) essentially provided in front of the photovoltaic cells (6).

2. The solar cell module (1) according to claim 1, wherein the photovoltaic cell module (5) is attached in a recess (4) of the rear housing with a volume adhesive (8), wherein the upper side (9) of the rear housing and the upper side (10) of the photovoltaic cell module (5) are flush.

3. The solar cell module (1) according to claim 1 or claim 2, wherein each window (30) defined by the grid webs (21, 22, 23) has a window surface smaller than 500 mm².

4. The solar cell module (1) according to any one of claims 1 to 3, wherein the grid (20) is made of a punched metal sheet, optionally covering side walls and/or back walls of the rear housing (3).

5. The solar cell module (1) according to claim 4, wherein the grid (20) is attached to the photovoltaic cell module (5) and the rear housing (3) with an adhesive (38).

6. The solar cell module (1) according to claim 5, wherein the adhesive is a non-conductive adhesive (38).

7. The solar cell module (1) according any one of claims 1 to 3, wherein the grid (20) is printed as a screen print of conductive material on the upper surface (10) of the photovoltaic cell module (5) and partly on the surrounding rear housing (3).

8. A method producing a solar cell module (1) according to any one of claims 1 to 6, providing a rear housing (3), positioning a photovoltaic cell module (5) in the rear housing (3), providing a conductive grid (20), applying an adhesive (39) either on the back side (31) of the conductive grid (20) or on positions complementary to the grid (20) on the photovoltaic cell module (5) and on the rear housing (3), and attaching the grid (20) on the photovoltaic cell module (5) and on the rear housing (3).

9. The method according to claim 8, wherein the grid (20) is pre-bent in the direction on the surface of the photovoltaic cell module (5) to ensure a good contact on the photovoltaic cell module (5).

10. The method according to claim 8 or 9, wherein positioning the photovoltaic cell module (5) in the rear housing (3) comprises the steps of applying a volume adhesive (8) in a recess (4) in the rear housing (3), positioning the photovoltaic cell module (5) in the recess (4) in a way that the upper surface of the photovoltaic cell module (5) is flush with the upper surface of the rear housing (9), and hardening of the volume adhesive (8).

11. The method according to any one of claims 8 to 10, wherein an additional housing comprising a conductive layer is provided encompassing the rear housing (3) as well as contacting the complete edge area of the grid (20).
